# EUROPEAN PATENT APPLICATION

(11) **EP 3 982 398 A1**
(43) Date of publication of application: **13.04.2022**
(21) Application number: 20200373.7
(22) Date of filing: 06.10.2020
(51) Int. Cl.: H01L 21/67

(54) **CONTROLLED LOCAL HEATING OF SUBSTRATES**

(71) Applicant: Nederlandse Organisatie voor toegepast- natuurwetenschappelijk Onderzoek TNO, 2595 DA 's-Gravenhage (NL)
(72) Inventor: HENDRIKS, Rob Jacob, 2595 DA 's-Gravenhage (NL)
(74) Representative: V.O.

(57) **Abstract**

The present disclosure provides an apparatus for controlled local heating a target surface (41) of a substrate (40) provided with a heat sensitive material (43) to change a state of said material. The apparatus comprises a carrier (3) having a carrier surface (36) for carrying the substrate (40) at a carried surface (42) opposite the target surface. The carrier has a plurality of laterally distributed heating zones (30, 30a, 30b,..., 30n) which are thermally insulated from each other, the respective heating zones comprise respective resistive heating elements (32, 32a, 32b,..., 32n) and are thermally coupled to a heat sink (2). The apparatus further comprises a controller to control a selective supply of electric energy to at least one of the respective resistive heating elements comprised in at least one of the plurality of laterally distributed heating zones.

## Description

### The invention

The present application pertains to an apparatus for controlled local heating of a material on substrate.

The present application further pertains to a method of controlled local heating of a material on a substrate.

The present application also pertains to a record carrier comprising a computer program that causes a programmable device to perform said method.

The present application still further pertains to a manufacturing arrangement comprising the apparatus.

Nowadays flexible electronics are made with expensive polyimide substrates and etched copper circuits. As such substrates can withstand reflow soldering temperatures, industrially standard lead-free solder pastes such as SAC305 can be used to mount electronic components.

US6278078 for example describes a laser soldering method. A laser is used to heat metallic components to be soldered, and a wavelength of the laser is chosen based in light absorption characteristics of the metallic components. A soldering location at which the laser forms a beam spot is located at a predetermined distance away from a focus of the laser beam, so that the beam spot is defocused and has a uniform intensity across its area. Exemplary materials suggested therein for the substrate Kevlar.TM., polyimide, and cynate ester.

For cost reduction it is desired to use cheaper substrates, such as PET. Such cheaper substrates however typically have glass transition temperatures that are substantially lower than that of polyimide substrates. Accordingly, there is a need for a solutions that enable such thermal processes to be performed using cheaper substrates.

### SUMMARY

Accordingly it is an object to provide an improved apparatus for a controlled local heating of a material on a substrate provided with a heat sensitive material at a target surface thereof.

Accordingly it is a further object to provide an improved method of controlled local heating of a material on a substrate provided with a heat sensitive material at a target surface thereof.

According to the present disclosure the improved apparatus provided herewith comprises a carrier having a carrier surface for carrying the substrate at a carried surface opposite the target surface, the carrier having a plurality of laterally distributed heating zones which are thermally insulated from each other. The respective heating zones comprise respective resistive heating elements and are thermally coupled to a heat sink.

The improved apparatus further comprises a controller to control a selective supply of electric energy to at least one of the respective resistive heating elements comprised in at least one of the plurality of laterally distributed heating zones.

In operation, the controller selectively energizes a resistive heating element in a heating zone having a lateral position corresponding to that of a spot on the target surface of the substrate. Therewith the resistive heating element induces a heat flow that partly flows via the carrier surface through the substrate to the target surface thereof, so that the heat sensitive material is heated causing a change of its state. Due to the fact that the laterally distributed heating zones are thermally insulated from each other and the fact that they are thermally coupled to a heat sink, heating of neighboring heating zones is mitigated, so that a deformation of the substrate is avoided.

In an embodiment, the carried surface of the substrate and/or the carrier surface of the carrier is provided with an adhesive layer. An adhesive layer, such as a PDMS layer, helps to maintain the carried surface of the substrate in good contact with the carrier surface of the carrier, even if the substrate locally deforms as a result of supplied heat. Therewith an adhesive layer promotes a good transfer of heat to the target surface. Preferably, the adhesive layer is provided at the carried surface of the substrate. This simplifies maintenance of the carrier surface.

In an embodiment of the improved apparatus the plurality of laterally distributed heating zones are thermally insulated from each other in that the carrier defines slits that extend along portions of boundaries between mutually neighboring heating zones, the slits being in communication with an evacuation channel. The vacuum prevailing in the slits at the boundary between mutually neighboring heating zones provides for a very efficient insulation. In alternative embodiments, the slits fully extend along the boundary of the heating zones in the carrier. In that case the heating zones are each separately supported by a respective protrusion on the heat sink.

Furthermore, as a result of the vacuum provided at the carrier surface, an atmospheric pressure at the target surface of the substrate will firmly press the substrate to the carrier, therewith contributing to a good thermal contact between the carrier and the substrate, even in the absence of an adhesive layer.

Optionally, in this embodiment, the carried surface of the substrate and/or the carrier surface of the carrier is provided with an anti-stick layer. This is based on the consideration that it may be desired in some cases to locally heat the substrate to an extent at which the substrate locally melts. The anti-stick layer renders it possible to easily remove the substrate from the carrier despite the fact that the substrate has been temporarily molten at such locations. A material for the anti-stick layer may be selected from a metal, such as aluminum, or a ceramic material, such as silicon oxide, silicon nitride, aluminum oxide etc.

In an embodiment of the improved apparatus, the heating zones of the carrier are supported by respective protrusions of the heat sink. The protrusions can contribute in controlling a lateral temperature distribution in the heating zone. For example, when it appears in practice that the temperature in the center of the heating zones tends to be relatively high as compared to its periphery pyramid shape protrusions can be provided having their (truncated) top in contact with the carrier in the centers of the heating zones. The inventor recognized that a flow of heat between mutually neighboring heating zones may take place via a path through the heat sink. The protrusions strongly contribute in mitigating a lateral heat flux in the cooled vacuum chuck, while at the same time have a controlled and strong heat sink effect in vertical direction. To achieve this, each heating zone is provided with a respective pillar structure of a highly thermally conductive material that is connected to the heat sink, which is preferably provided with a controlled cooling source (e.g. water cooling). The pillar like structure improves the thermal insulation between neighboring heating zones as the height of the protrusions contribute to the length of the path through the heat sink. The higher the protrusions, the longer the distance, the higher the thermal contrast. Lateral thermal insulation is required for both the heater plate (pixel), as well as for the vacuum chuck.

The present disclosure further provides a manufacturing arrangement that comprising in addition to an improved apparatus as described above also a sensing unit and a feedback unit. The sensing unit is to provide a sense signal indicative for an observed process temperature. The feedback unit cooperates with the controller to cause the controller to provide control signals so as to minimize a deviation between the observed process temperature as indicated by the sense signal and a desired value of the process temperature as indicated by a target signal. The manufacturing arrangement provided with the feedback unit and the sensing unit renders possible an easy adaptation to different material properties. The process temperature to be controlled is for example a temperature at the target surface. The desired value to be achieved may for example depend on the type of heat sensitive material that is to be treated. In one example, the heat sensitive material is a solder and the desired value is the melting temperature of the solder. In another example, the heat sensitive material is a heat curable suspension or a heat curable precursor for a polymer and the desired value is the curing temperature of the curable suspension or the heat curable precursor. As another example, it may be desired to use the manufacturing arrangement for different substrate thicknesses. With this manufacturing arrangement the heat flow is automatically adapted to a level with which the desired value of the process temperature is properly approximated.

In an embodiment of the manufacturing arrangement the sensing unit comprises a thermal camera arranged to determine a temperature distribution at the target surface of the substrate. Regardless a thickness of the substrate used, the sense signal provided by the thermal camera enables the feedback unit to control the processing temperature at any particular location so that heat sensitive material is properly heated and that the measured process temperature does not exceed an upper limit determined by the substrate.

In an embodiment, the sensing unit alternatively or additionally comprises a respective temperature sensor for each resistive heating element to provide a sense signal indicative for the temperature of the resistive heating elements. Due to the fact that the change in temperature near the resistive heating elements leads the change in temperature at the target surface of the substrate, the controller can more rapidly control the heat flow to avoid an overheating of the substrate. In a combination of these measures, a primary feedback loop may be provided to control the target surface temperature, and a secondary feedback loop may be provided that interrupts heating if it detects a temperature that exceeds an allowed maximum value.

In an embodiment of the sensing unit, the resistive heating elements may serve as the temperature sensors in that the resistance of the resistive heating elements is indicative for its temperature. Alternatively, separate elements, such as thermo couples may be provided for temperature sensing.

In an embodiment of the manufacturing arrangement the controller is configured to provide control signals for providing electric energy in a pulse width modulated manner. Pulse width modulation allows for a very accurate control of the process temperature. In some examples thereof, the controller is configured to provide control signals for providing electric energy in an interleaved pulse width modulated manner. In this approach a heating cycle is repeated, wherein in each heating cycle mutually different heating zones are heated in mutually different phases of each heating cycle. This is based on the observation that resistive elements of mutually different heating zones may have energy supply leads with mutually different lengths, and hence with a mutually different resistance. This would have as the result that mutually different resistive element which are powered at the same time have a mutually different current density depending on their supply lead length. Furthermore, resistive heating elements may have a temperature dependent resistance, which also affects the heat flux distribution. By providing the control signals in an interleaved pulse width modulated manner it is achieved that only resistive heating element(s) for a single heating zone are energized at a time. A more time-efficient operation is achieved due to the fact that during the OFF-phase of one heating zone electric energy can be provided to another heating zone or heating zones.

In an embodiment, the manufacturing arrangement further comprises a substrate transport device to transport the substrate over the carrier surface. In this embodiment processing can take place as a continuous process. Furthermore, an even more efficient cooling is achieved due to the fact that the substrate is transported away from the carrier surface after completion of the processing step.

The present disclosure further provides an improved manufacturing method for controlled local heating a target surface of a substrate that is provided with a heat sensitive material to change a state of said material. The improved method comprises the following steps:
providing a carrier with a plurality of laterally distributed heating zones which are thermally insulated from each other, the respective heating zones comprising respective resistive heating elements and being thermally coupled to a heat sink;
with a carrier surface of the carrier carrying the substrate at a carried surface opposite the target surface;
selectively providing electric energy to at least one of the respective resistive heating elements comprised in at least one of the plurality of laterally distributed heating zones.

In an embodiment electric energy is provided in a pulse width modulated (PWM) manner, optionally in an interleaved pulse width modulated (IPWM) manner.

The present disclosure further provides a computer program, which when executed by a programmable processor causes the programmable processor to carry out any of the steps of the improved method.

### BRIEF DESCRIPTION OF THE DRAWINGS

These and other aspects are described in more detail with reference to the drawing. Therein:
FIG. 1 schematically shows an embodiment of a manufacturing apparatus for controlled local heating a target surface of a substrate provided with a heat sensitive material to change a state of said material;
FIG. 2 shows aspects of the apparatus in more detail;
FIG. 3 shows in more detail a portion of an embodiment of the manufacturing apparatus near a heating zone thereof;
FIG. 4 shows an alternative embodiment of the apparatus in more detail;
FIG. 5 shows a top view of an aspect of the apparatus;
FIG. 6 shows in more detail a portion of an embodiment of the manufacturing apparatus near a heating zone thereof;
FIG. 7A and 7B schematically shows an operation of an embodiment of the apparatus using interleaved pulse width modulation IPWM; Therein FIG. 7A shows a surface of an exemplary substrate 40 and FIG. 7B shows how electrical energy is supplied as a function of time to various zones of the substrate.
FIG. 8 shows an exemplary manufacturing arrangement that comprises a substrate transport device in addition to an embodiment of the apparatus;
FIG. 9 shows an alternative experimental setup;
FIG. 10A-10D shows various stages of a sample substrate which was processed with this alternative experimental setup;
FIG. 11A, 11B, 11C shows results obtained with a simulation for respective values for a thickness of the carrier;
FIG. 11D shows a version of the simulation for pulse width modulated heating.

### DETAILED DESCRIPTION OF EMBODIMENTS

Like reference symbols in the various drawings indicate like elements unless otherwise indicated.

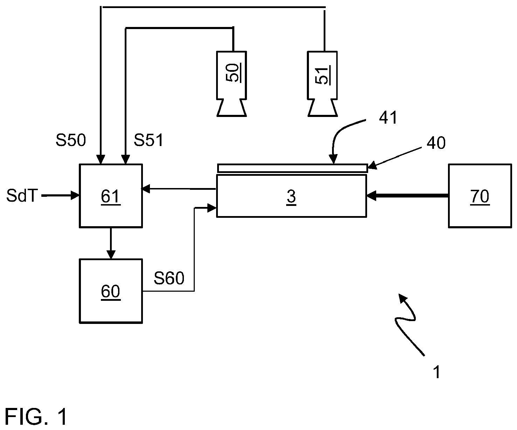

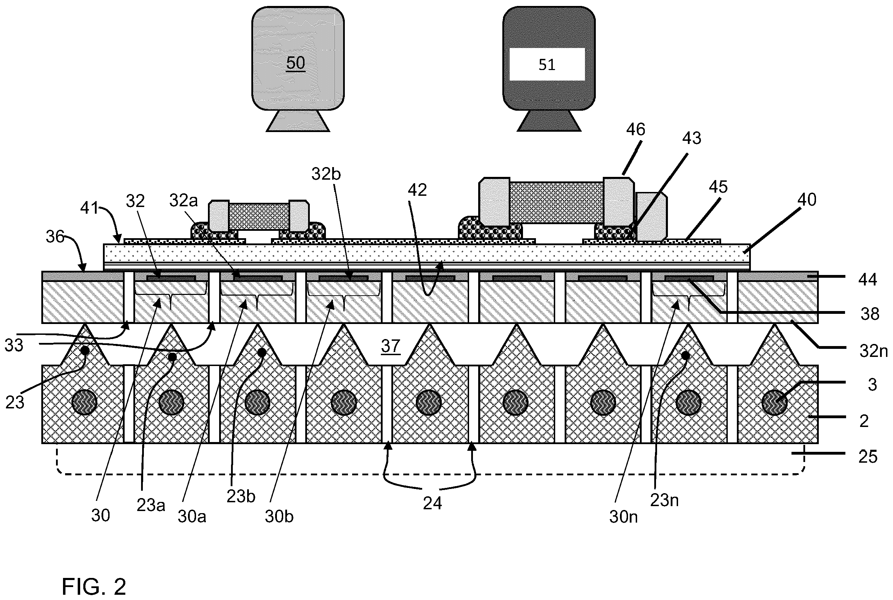

FIG. 1 schematically shows a manufacturing apparatus 1 for controlled local heating a target surface 41 of a substrate 40 provided with a heat sensitive material to change a state of said material. As shown in more detail in FIG. 2, the apparatus comprises a carrier 3 having a carrier surface 36 for carrying the substrate 40 at a carried surface 42 opposite the target surface. The carrier 3 has a plurality of laterally distributed heating zones 30, 30a, 30b,..., 30n which are thermally insulated from each other. The respective heating zones each comprise a proper resistive heating element 32, 32a, 32b,..., 32n and are thermally coupled to a heat sink 2. As shown in FIG. 1, a controller 60 is provided to control a selective supply of electric energy to at least one of the respective resistive heating elements comprised in at least one of the plurality of laterally distributed heating zones. In the embodiment shown the electric energy is supplied by supply source 70, and the controller 60 outputs control signals to respective switching elements to selectively connect the resistive heating elements to said electric supply source.

In the example of FIG. 1, the manufacturing apparatus 1 is part of a manufacturing arrangement that further comprises a sensing unit 51 and feedback unit 61. In operation, the sensing unit 51 provides a sense signal S51 indicative for an observed process temperature. The feedback unit 61 cooperates with the controller 60, to cause the controller 60 to provide control signals S60 so as to minimize a deviation between the observed process temperature as indicated by the sense signal S51 and a desired value of the process temperature as indicated by a target signal SdT. In this example, the sensing unit 51 comprises a thermal camera arranged to determine a temperature distribution at the target surface 41 of the substrate 40. Also in addition, a high resolution camera 50 is provided that outputs a video signal S50.

The controller 60 may use the video signal to accurately determine locations of the various objects on the substrate. Additionally or alternatively, the sensing unit may comprise a respective temperature sensor for each resistive heating element 32, 32a, 32b,..., 32n to provide a sense signal indicative for their temperature. In the example shown, the target surface 41 is provided with electrically conductive circuit 45 and electronic components 46, e.g. active components like transistors and integrated circuits and passive components like resistors, capacitors, and inductances are to be electrically connected thereto by solder paste 43. Instead of a solder paste, a heat curable ink comprising electrically conductive particles may be applied. Additionally or alternatively, the heat sensitive material at the target surface 41 may be a heat curable polymer which serves adhere components or thermally insulate components for example.

In the example shown in FIG. 2, the plurality of laterally distributed heating zones 30, 30a, 30b,..., 30n are thermally insulated from each other in that the carrier 3 defines slits 33 that extend along portions of boundaries between mutually neighboring heating zones e.g. between 30 and 30a. The slits 33 communicate with an evacuation channel 37. In operation the evacuation channel 37 is coupled via further slits 24 in the heat sink 2 and a vacuum channel 25 to a vacuum pump. As a result the environmental pressure firmly presses the substrate 40 to the carrier surface 36 of the carrier 3. As a consequence thereof, an excellent thermal contact is provided for between the carrier surface 36 of the carrier 3 and the carried surface 42 of the substrate 40. By the same measure, thermal insulation between mutually adjacent heating zones is improved. It is noted that in alternative embodiments slits are provided that fully extend along the boundaries of the heating zones in the carrier 3. This even further improves the thermal insulation between neighboring heating zones. It that case the carrier is non-integral, and the heating zones are supported by respective protrusions of the heat sink 2. In this connection it is noted that the carried surface 42 of the substrate 40 is provided with an anti-stick layer 44. Therewith, upon completion of the heat treatment, the substrate 40 can be easily removed from the carrier 3, even in the case that the substrate 40 locally melted during the heat treatment. Alternatively, or additionally the carrier surface 36 of the carrier 3 may be provided with an anti-stick layer. In the embodiment shown, the resistive heating elements 32, 32a, 32b,...,32n are embedded in an electrically insulating layer 38 which may additionally serve as an anti-stick layer.

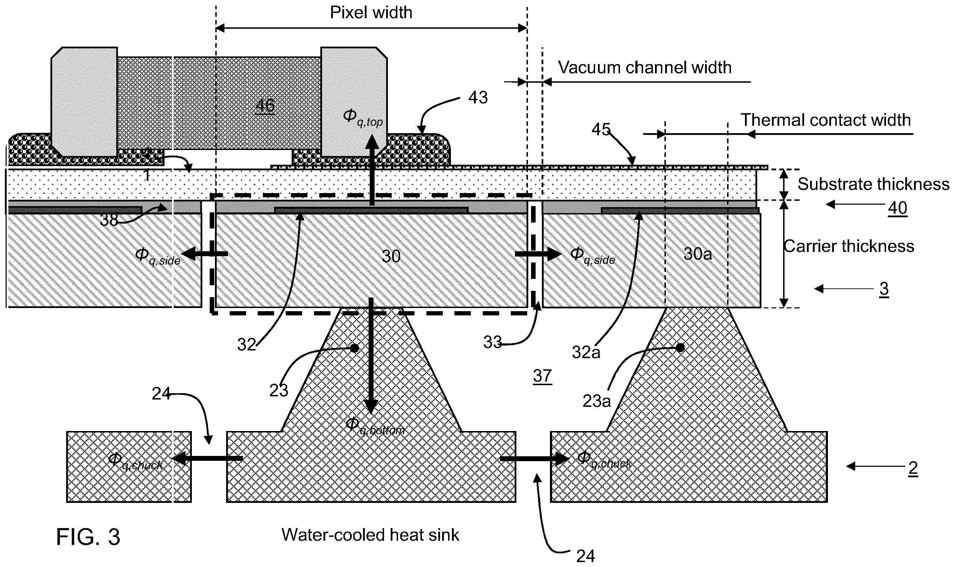

In the embodiment of FIG. 2, the heating zones 30, 30a, 30b,..., 30n of the carrier 3 are supported by respective protrusions 23, 23a, 23b, ...., 23n of the heat sink 2. As set out in more detail with reference to FIG. 3, in this way a thermal insulation between mutually neighboring heating zones 30, 30a is further improved.

FIG. 3 shows a portion of the manufacturing apparatus near the heating zone 30 in more detail. By way of example, for a particular time interval, the controller 60 has selected resistive heating element 32 as the one to be supplied with electric energy. As a result heat is developed therein, which results in a flow of heat Φq,top through the substrate 40 towards the solder paste 43, which is to be molten to mechanically and electrically connect a terminal of the component 46 to the electrically conductive circuit 45. A second, lateral flow of heat indicated as Φq,side occurs. This second heat flow is strongly mitigated due to the thermal insulation between the heating zones 30, 30a. In this case the evacuated slits 33 contribute to that thermal insulation. A third heat flow Φq,bottom occurs in the direction of the heating zone 30 via the protrusion 23 to the heat sink 2. A portion of the flow of heat Φq,bottom in that direction results in a further lateral flow of heat Φq,chuck within the heat sink. The heat conduction path formed by the protrusions 23, 23 ... allows the heating zones to rapidly cool down after the supply of electric energy is interrupted and mitigates a conduction of heat towards mutually neighboring heating zones.

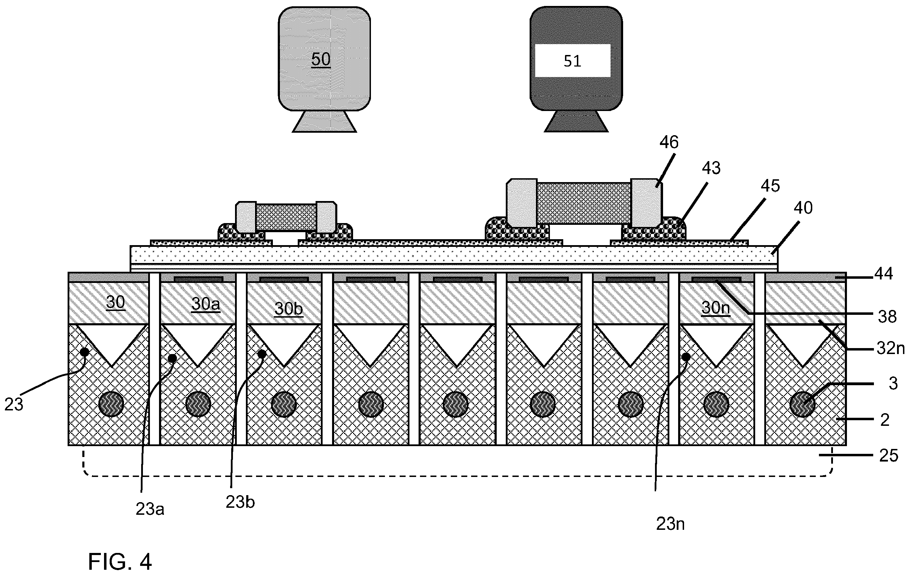

In the embodiment shown in FIG. 2, and in more detail in FIG. 3, the protrusions 23, 23a, 23b,...,23n are formed as truncated pyramids. In the alternative embodiment of FIG. 4 the protrusions 23, 23a, 23b, ..., 24 are formed as inverse pyramids, that support the heating zones 30, 30a, 30b, ..., 30n at their edges.

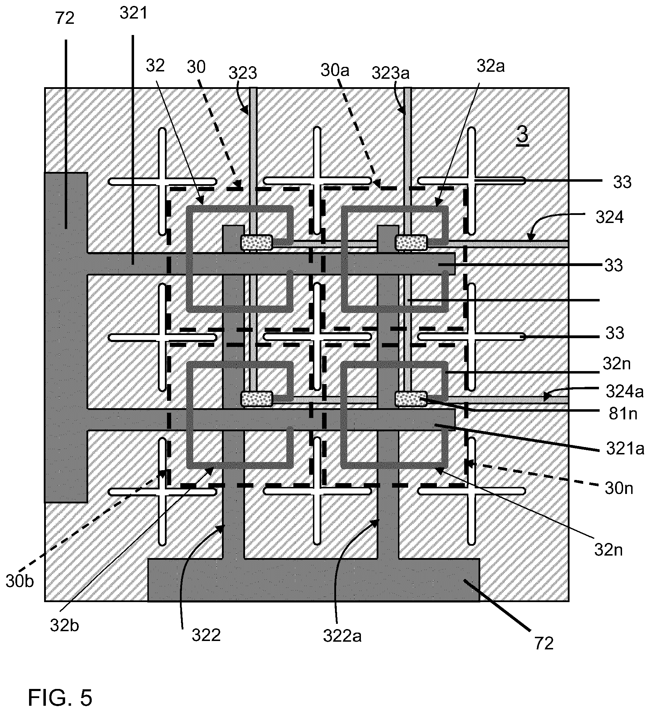

FIG. 5 shows a top view of the carrier 3 in an embodiment of the manufacturing apparatus having heating zones 30, 30a, 30b, ..., 30n with a respective resistive heating element 32, 32a, 32b, 32n controlled by a respective switching element, e.g. 81n. In the embodiment shown, the resistive heating elements 32, 32a, 32b, 32n are coupled at a first end to a first power line 321, 321a which in turn are electrically connected via a first busbar 71 with an anode of the power supply 70. The resistive heating elements 32, 32a, 32b, 32n are coupled at a second end via their respective switching element to a second power line 322, 322a which in its turn is electrically connected via a second busbar 72 with an cathode of the power supply 70. The first power lines 321, 321a extend in mutually transverse directions. The switching elements are controlled by a respective pair of a first control line 323, 323a and a second control line 324, 324a. A switching element, e.g. 81n is addressed to assume a conducting state if both its first control line, in this example 323a and its second control line, in this example 324a are provided with an enable signal by the controller 60.

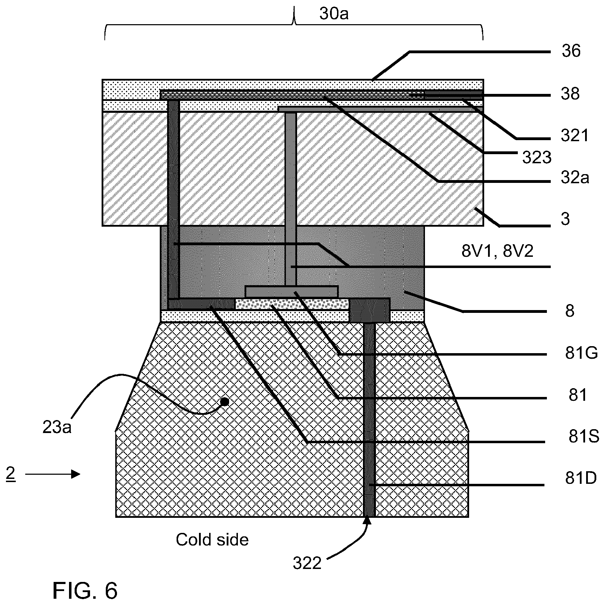

FIG. 6 shows in more detail, another example of a heating zone 30a, having its resistive heating element 32a coupled to power supply lines 321 and 322 via an switching element 81. In the example shown the switching element 81 is arranged at a silicon carrier 8 at the side of the heat sink, i.e. at the side of the carrier that is supported by a protrusion 23a of the heatsink 2. The resistive heating element 32a is connected at one end to an anode 321 extending in the plane of the carrier 3 and at the other end it is connected with a conductor that extends through a via 8V1 in the carrier 3 to a first main terminal of a switching element 81, here the source 81S of a FET. A second main terminal of the switching element 81, here the drain 81D of the FET is connected to the power supply line 322. The switching element 81 is controlled by a control line 323 that extends in the plane of the carrier 3 in a direction transverse to that of the power supply lines 321 and is connected by an electric connection through a second through hole via 8V2 to a control electrode of the switching element 81, here the gate 81G of the FET. In this example the switching element 81 is rendered into a conducting state by the control signal from the control line 323. In some embodiments each switching element 81 may have a proper control line 321. Alternatively the switching elements arranged in a same row or column may share a common control line and a resistive heating element 32 in a particular heating zone along the selected row or column may be activated by further connecting the anode 321 to which that resistive heating element 32 is connected.

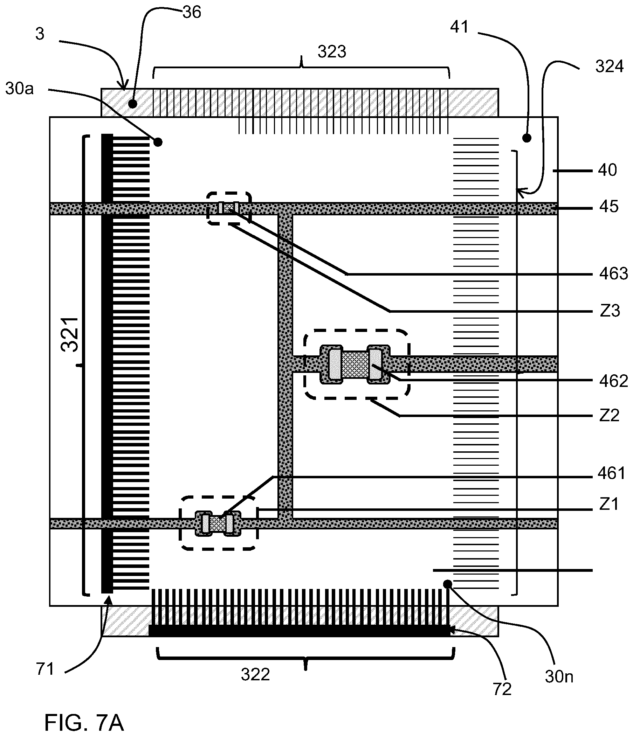

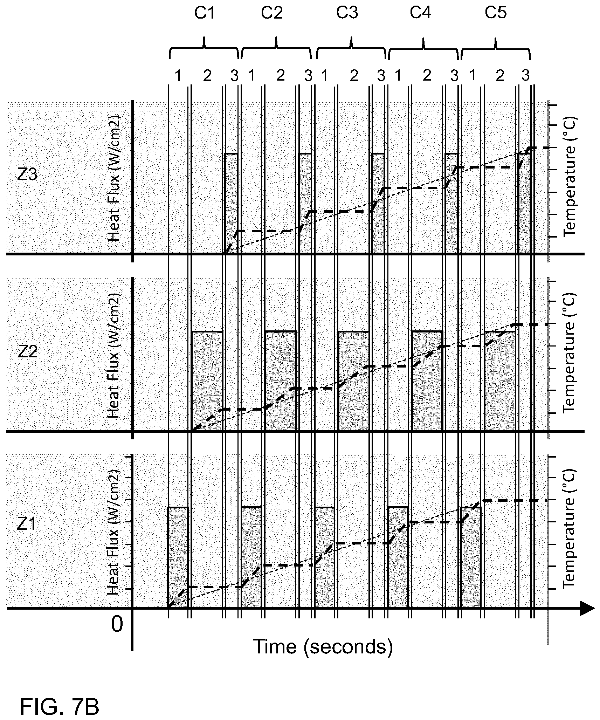

FIG. 7A and 7B schematically shows how interleaved pulse width modulation IPWM is used to heat solder material in mutually different substrate zones Z1, Z2, Z3 at a substrate surface. Therein FIG. 7A shows a surface of an exemplary substrate 40 and FIG. 7B shows how electrical energy is supplied as a function of time to the various substrate zones.

As shown in FIG. 7A, the substrate 40 is arranged at a carrier surface 36 of the carrier 3. The substrate 40 comprises at its surface 41 a plurality of electrically conductive tracks. In each of the substrate zones Z1, Z2, Z3 a respective electronic component 461, 462, 463 is to be connected to the tracks 45 with a solder joint. The carrier 3 comprises a plurality of heating zones 30a,..., 30n which can be heated by respective resistive heating elements (not shown) which can be provided with electric energy with a respective pair of a row line 321 connected to busbar 71 and a column line 322 connected to busbar 72. In operation the busbars are coupled to a power supply source. The resistive heating elements are selectively energized by a proper switching element (not shown) which is controlled by a respective pair of a first control line 323 and a second control line 324.

As shown in FIG. 7B, the three substrate zones Z1, Z2, Z3 are heated in a plurality of cycles (In this example five cycles C1, C2, C3, C4, C5. In a first phase 1 of each cycle, the first substrate zone Z1 is heated, in the second phase 2, the second substrate zone Z2 is heated and in the third phase 3, the third substrate zone Z3 is heated.

Accordingly, during each phase, only one of the zones is heated at a time, so that the voltage available for operation of a resistive heater is not affected by an electrical load imposed by other resistive heaters. It may be the case that a substrate zone comprises a plurality of heating zones. In that case one or more or all of the plurality of heating zones of a substrate zone may be activated during the phase wherein that substrate zone is to be heated. It is still avoided in that case that the operation of the resistive heaters in that substrate zone affect the operation of resistive heaters in other substrate zones.

In this example the amount of solder to be heated in the various heating zones mutually differs. In accordance therewith the duration of the third phase is longer than the duration of the first phase and in turn, the duration of the second phase is longer than the duration of the first phase. Therewith it is achieved that the increase in local temperature for the three substrate zones is substantially the same. An efficient operation is achieved that the heat flow is intermitted at a local scale to avoid an overheating whereas at a global scale heat supply takes place in a continuous manner. The shaded blocks in FIG. 7B indicate the phases wherein energy is supplied to a particular one of the substrate zones. The thick broken lines represent the actual temperature development occurring in the substrate zones and the thin broken lines show the trend lines for this development.

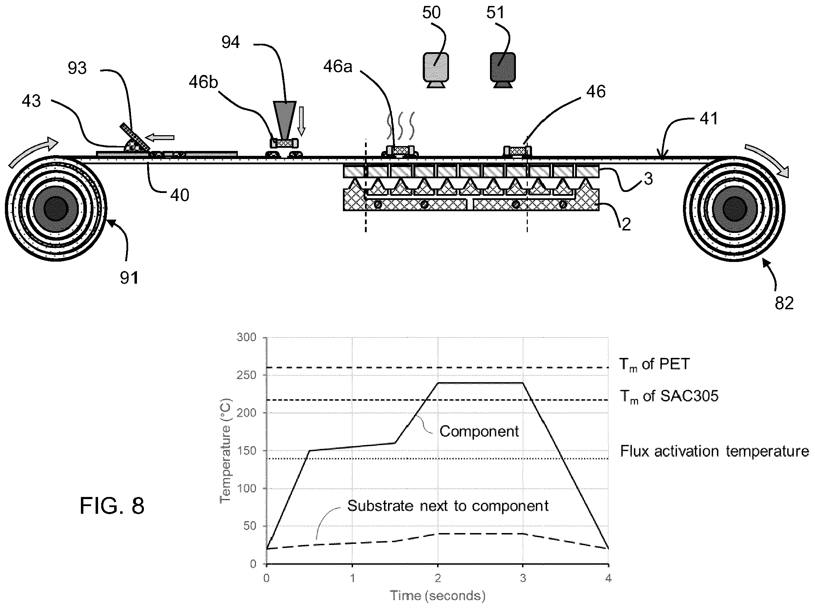

An exemplary manufacturing arrangement is shown in FIG. 8 that comprises in addition to the apparatus as described with FIG. 1 or its modifications a substrate transport device 91, 92 to transport the substrate 40 over the surface of the carrier 3. In this example the substrate transport device is depicted as a combination of an unwind roller 91 comprising the raw substrate or in this case a substrate 40 with electrically conductive lines and a winding roller 92 that serves to collect the processed substrate. In practice various support rolls and other guidance elements may be present. In the example shown a deposition device 93 deposits a quantity of a heat sensitive material, here a solder 43 and a placement device 94 positions components 46, 46a, 46b on the surface 41. In a subsequent locally controlled heating step, heat is provided in a locally controlled manner to heating zones of the target surface 41 comprising a component to be soldered. In the example shown, component 46a is soldered by locally heating its heating zone. The continuous movement of the substrate in the roll to roll process further contributes to a better temperature management of the substrate 40. This is schematically illustrated in the graph at the same page which shows the development of the component temperature and the temperature of the substrate in the environment of the component. The terminals of the component, e.g. 46a are temporarily heated to a temperature exceeding the melting temperature of the solder 43 (e.g. SAC305), but below the melting temperature of the substrate (e.g. PET). However, the environment of the substrate near the component is remains relatively low.

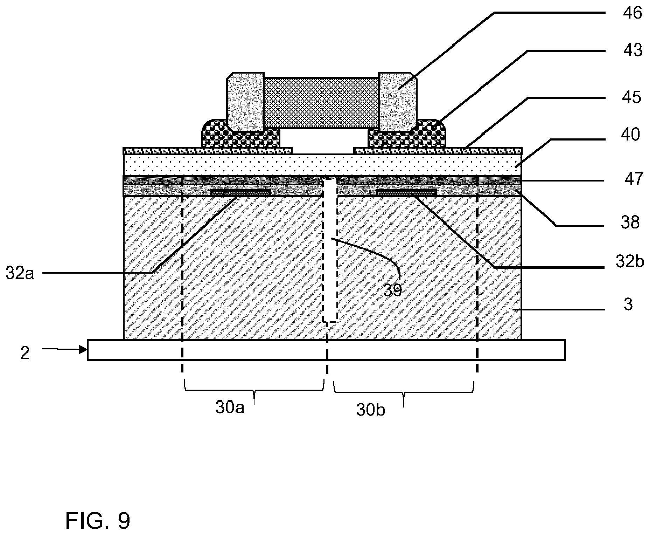

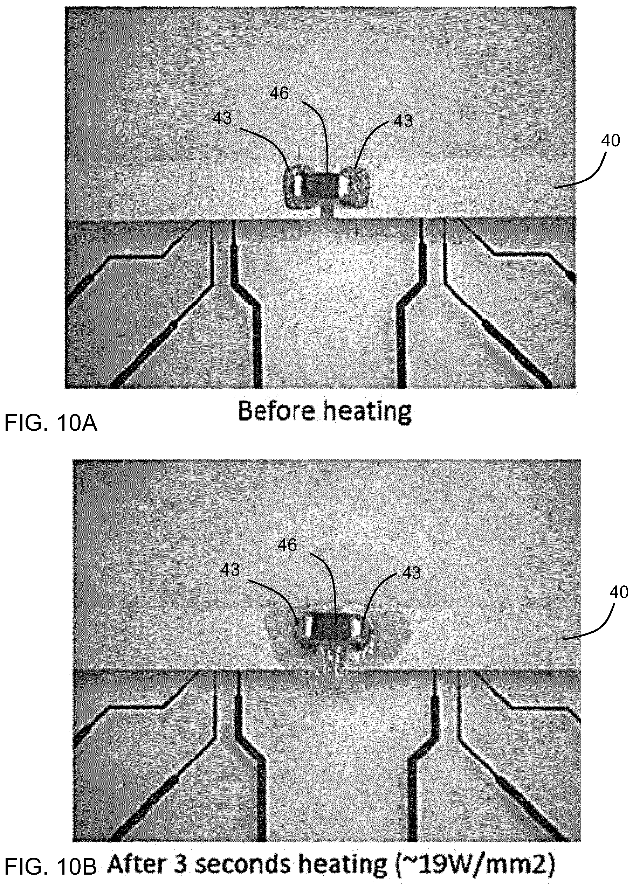

FIG. 9 shows an alternative experimental setup. Parts therein corresponding to those in FIG. 2 have a corresponding reference number. Contrary to the embodiment of FIG. 2, an adhesive layer 47 (in this example a 5 micron thick layer of DuPont PE773) is used to provide for a firm thermal contact between the carrier 3 and the substrate 40. The carrier 3 in this case is a glass layer (here type Eagle XG) having a thickness of 700 micron. The carrier is provided with two heating zones 30a, 30b each having a proper resistive heating element 32a, 32b of 0.125 micron thick Molybdenum. The resistive heating element 32a, 32b are embedded in a 0.5 micron thick silicon nitride layer. The sample upon which the experiment was conducted is shown in FIG. 10A-10D in various stages and comprises a substrate 40 formed by a 125 micron PET-layer (Melinex ST504). The conductors 45 thereon are formed of 15 µm thick material type Heraeus LTC3501A. The solder paste 43 used is of type SAC305 T4).

Both resistive heating elements 32a, 32b have a resistance of around 400 Ohms and in this experimental setup were driven in parallel with one constant voltage source which was set at 30 volts. Because of the high lead resistance of 200 Ohms, the efficiency of the heater is around 66%. The size of each resistive heating element is 200 x 400 µm2, or 0.08 mm2. This results in a quite high local heat flux of around 19 W/mm2. With an optimized heater design and stack that includes vacuum channels, a lower heat flux of about 0.5 - 2 W/mm2, would suffice, as less of the generated heat can leak away to the periphery. However, already an improved thermal insulation could be achieved by providing air gaps 39 between mutually neighboring heating zones 30a, 30b.

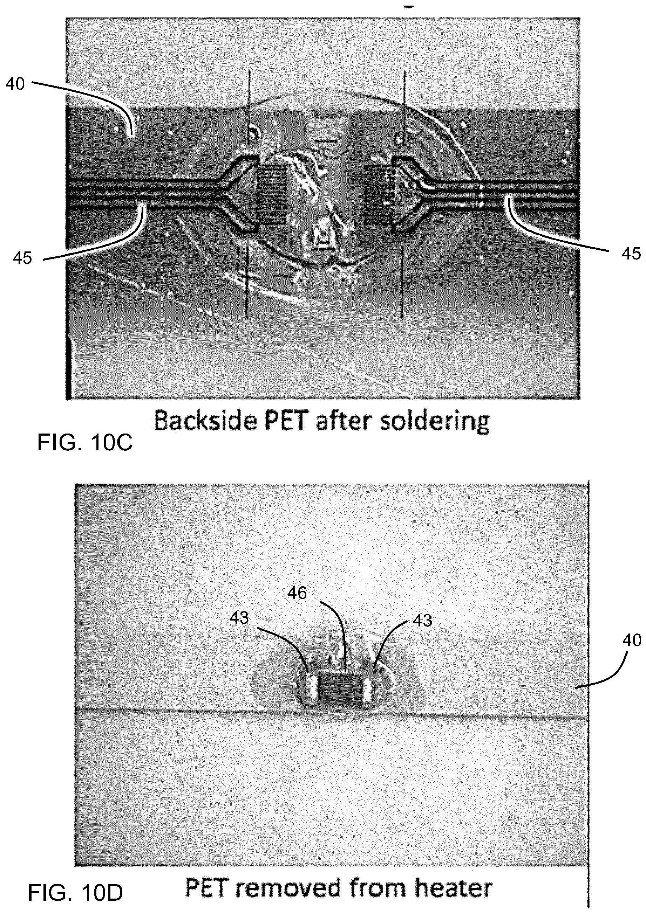

FIG. 10A shows a top view of the sample in its original state. The soldering time in this setup was around 3 second. The sample upon completion of this processing step is shown in FIG. 10B, 10C, 10D. Therein FIG. 10B shows a top view of the processed sample, FIG. 10C shows a back view and FIG. 10D again shows the top view after removal from the carrier 3. As becomes apparent from FIG. 10B and FIG. 10D, the solder 43 was properly molten during the processing step, so as to electrically connect the component 46. However, during the soldering the adhesive 47 started to outgas, resulting in an air gap between the substrate 40 and the carrier 3 and as shown in FIG. 10C the substrate 40 did melt in this experiment. In industrial applications the controller properly controls the heat flow, so as to control the process temperature at a level that is sufficiently high to melt the solder 43, but below a level that would cause the substrate 40 to melt. Additional experiments with a hot plate indeed showed that soldering of SAC305 at around 230C - 240C is possible without melting the PET. The substrate became very soft and deformed significantly, but could be removed easily from the glass carrier. When the hot plate was set to 260C however, the PET melted and got stuck to the glass.

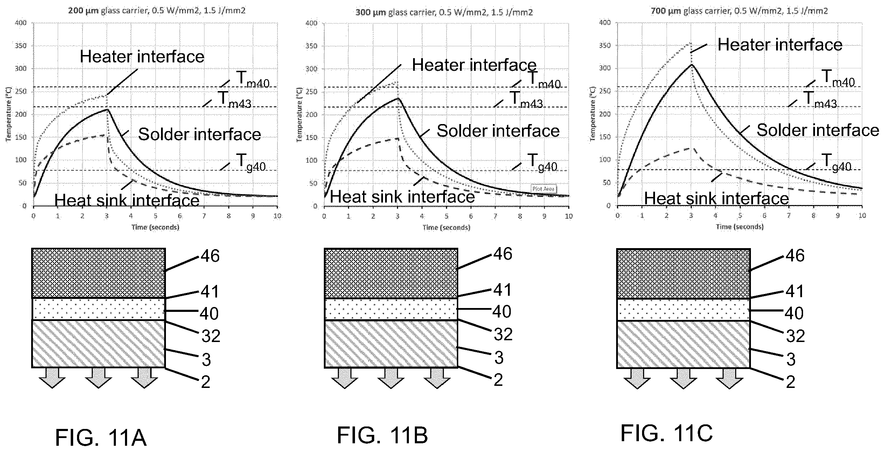

FIG. 11A, 11B, 11C shows a COMSOL type simulation in which a stack was modeled with a heat sink 2, a carrier 3 having a resistive heater 32 and carrying a substrate 40 with a component 46 at its target interface. The properties thereof in this model are as follows:
- the carrier 3 is a glass plate, having a variable thickness;
- the substrate 40 is a PET-layer having a thickness of 100 micron,
- the component 46 thereon is an Al2O3 layer with a thickness of 500 micron.
- the resistive heater 32 renders a heat flow of 0.5 W/mm² during 3 seconds, which results in a total heat production of 1.5 J/cm².
- the heat sink 2 has a capacity of 3 kW/m²K.
For each setting (200, 300, 700 micron) of the variable thickness of the carrier 3, the following temperatures are computed herein as a function of time:
- the temperature at the heat sink interface between the heat sink 2 and the carrier 3;
- the temperature at the heater interface between the carrier 3 and the substrate 40;
- the temperature at the solder interface between the substrate 40 and the component 46.
The measured curves for these settings are respectively shown in FIG. 11A, 11B, and 11C.

In the example of FIG. 11A, wherein the glass layer 3 is modeled with a thickness of 200 micron, it can be seen that a relatively large portion of the heat flow rendered by the resistive heating element 32 disappears via the heat sink 2. Therewith the temperature at the solder interface just approaches the melting temperature Tm43 of the solder, but this is insufficient to achieve a full reflow of the solder 43.

In the example of FIG. 11C, with a thickness of 700 micron for the glass layer 3, the temperature at the solder interface easily exceeds the melting temperature Tm43 of the solder 43, but also the temperature at the heater interface significantly exceeds the melting temperature Tm40 of the substrate 40. In an actual application this would imply that the substrate is destroyed.

In the example of FIG. 11B, the glass layer 3 is modeled with a thickness of 300 micron. It can be seen that in this case a proper balance is achieved wherein the temperature at the solder interface exceeds the melting temperature Tm43 of the solder 43 during a sufficiently long time to achieve a full reflow of the solder 43, but wherein the temperature at the heater interface only exceeds the melting temperature Tm40 of the substrate 40 during a short time interval so that the substrate 40 remains substantially undeformed and the component 46 can be safely soldered.

From the above, it is apparent that the skilled person can determine from case to case a proper dimensioning of the carrier using a few simple experiments or simulations.

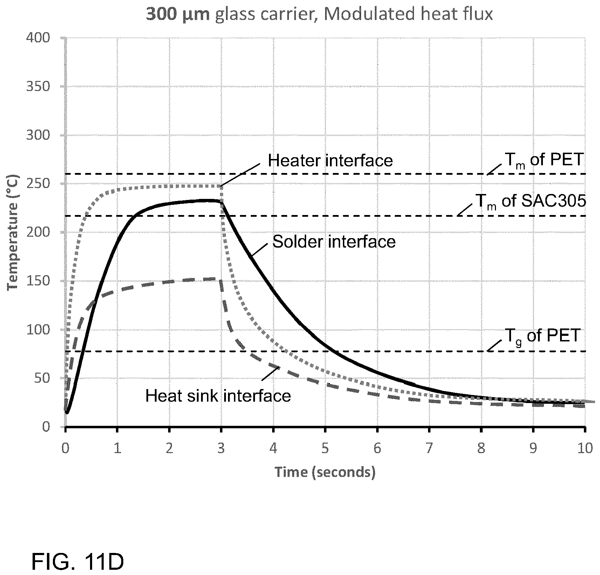

FIG. 11D shows a variation of the simulation discussed with reference to FIG. 11B. Also in this variation, the modeled thickness of the carrier 3 is 300 micron. Contrary to the case of FIG. 11B however, in this simulation electric energy is supplied to the resistive heating element in a pulse width modulated manner. In practice, this may be achieved by a feedback unit, e.g. a feedback unit 61 as shown in FIG. 2 which interrupts power supply to the resistive heater if the temperature at the heater interface tends to exceed the melting temperature Tm40 of the substrate 40. In this case the temperature at the solder interface can be maintained above the melting temperature Tm43 of the solder 43 while keeping the temperature at the heater interface below the melting temperature Tm40 of the substrate 40. Alternatively, if the properties of the substrate 40 are known, a feedforward controller may be used that controls the power supply to avoid that the melting temperature Tm40 is exceeded. As described with reference to FIG. 7A, 7B, during the time intervals wherein the power supply to a resistive heating element 32 is interrupted to moderate the temperature, power may be supplied to another heating element, to efficiently use the resources of the apparatus.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. A apparatus for controlled local heating a target surface (41) of a substrate (40) provided with a heat sensitive material (43) to change a state of said material, the apparatus comprising
a carrier (3) having a carrier surface (36) for carrying the substrate (40) at a carried surface (42) opposite the target surface, the carrier having a plurality of laterally distributed heating zones (30, 30a, 30b,..., 30n) which are thermally insulated from each other, the respective heating zones comprising respective resistive heating elements (32, 32a, 32b,..., 32n) and being thermally coupled to a heat sink (2),
a controller (60) to control a selective supply of electric energy to at least one of the respective resistive heating elements comprised in at least one of the plurality of laterally distributed heating zones.

2. The apparatus according to claim 1, wherein the carried surface (42) of the substrate and/or the carrier surface (36) of the carrier is provided with an adhesive layer (47).

3. The apparatus according to claim 1, wherein the plurality of laterally distributed heating zones (30, 30a, 30b,..., 30n) are thermally insulated from each other in that the carrier (3) defines slits (33) that at least extend along portions of boundaries between mutually neighboring heating zones, the slits being in communication with an evacuation channel (37).

4. The apparatus according to claim 3, wherein the carried surface of the substrate and/or the carrier surface (36) of the carrier is provided with an anti-stick layer (44).

5. The apparatus according to either of the preceding claims, wherein the heating zones of the carrier (3) are supported by respective protrusions (23, 23a, 23b, ...., 23n) of the heat sink (2).

6. The apparatus according to either of the preceding claims, wherein respective resistive heating elements are coupled to an electric power supply switched by respective switching elements that are controlled by said controller.

7. The apparatus according to claim 6, wherein the respective switching elements are accommodated in the heat sink.

8. A manufacturing arrangement comprising in addition to the apparatus according to one of the preceding claims:
a sensing unit (51) to provide a sense signal (S51) indicative for an observed process temperature;
a feedback unit (61) cooperating with the controller (60), causing the controller (60) to provide control signals (S60) so as to minimize a deviation between the observed process temperature as indicated by the sense signal (S51) and a desired value of the process temperature as indicated by a target signal (SdT).

9. The manufacturing arrangement according to claim 8, wherein the sensing unit comprises a thermal camera (51) arranged to determine a temperature distribution at the target surface (41) of the substrate (40).

10. The manufacturing arrangement according to claim 8 or 9, wherein the sensing unit comprises a respective temperature sensor for each resistive heating element to provide a sense signal indicative for the temperature of the resistive heating elements (32, 32a, 32b,..., 32n).

11. The manufacturing arrangement according to claim 8, 9 or 10, wherein the controller (60) is configured to provide control signals (S60) for providing electric energy in a pulse width modulated (PWM) manner.

12. The manufacturing arrangement according to claim 11, wherein the controller (60) is configured to provide control signals (S60) for providing electric energy in an interleaved pulse width modulated (IPWM) manner.

13. The manufacturing arrangement according to either of the claims 8-12, further comprising a substrate transport device (91, 92) to transport the substrate over the carrier surface.

14. A manufacturing method for controlled local heating a target surface (41) of a substrate (40) provided with a heat sensitive material (43) to change a state of said material, the method comprising:
providing a carrier (3) with a plurality of laterally distributed heating zones (30, 30a, 30b,..., 30n) which are thermally insulated from each other, the respective heating zones comprising respective resistive heating elements (32, 32a, 32b,..., 32n) and being thermally coupled to a heat sink (2), with a carrier surface (36) of the carrier (3) carrying the substrate (40) at a carried surface (42) opposite the target surface,
selectively providing electric energy to at least one of the respective resistive heating elements (32, 32a, 32b,..., 32n) comprised in at least one of the plurality of laterally distributed heating zones.

15. The method according to claim 14, wherein providing electric energy is in a pulse width modulated (PWM) manner, optionally in an interleaved pulse width modulated (IPWM) manner.

16. A computer program product comprising a computer program, which when executed by a programmable processor causes the programmable processor to carry out any of the steps of the method of one of claim 14 or 15.
